# FASCICULE DE BREVET EUROPEEN

(11) **EP 3 423 860 B1**
(45) Date de publication et mention de la délivrance du brevet: **05.01.2022**
(21) Numéro de dépôt: 17709386.1
(22) Date de dépôt: 24.02.2017
(51) Int. Cl.: G01S 3/784, H03K 5/24, H03K 19/0175, H03K 19/173

(54) **DISPOSITIF DE DÉTECTION D'UN SPOT LASER**
VORRICHTUNG ZUR ERKENNUNG EINES LASERFLECKS
DEVICE FOR DETECTING A LASER SPOT

(30) Priorité: 29.02.2016 FR 1600330
(43) Date de publication de la demande: 09.01.2019
(73) Titulaire: Safran Electronics & Defense, 75015 Paris (FR)
(72) Inventeur: MARTINEZ, Alain, 77550 Moissy-Cramayel (FR)
(74) Mandataire: Lavaud, Thomas
(86) Numéro de dépôt international: PCT/EP2017/054400
(87) Numéro de publication internationale: WO 2017/148832

(56) Documents cités:
- EP-A1- 2 759 848
- WO-A1-2011/029651
- JP-A- 2005 326 340
- US-A1- 2009 079 956

## Description

La présente invention concerne le domaine des capteurs optiques matriciels pour la détection d'un spot laser projeté dans un champ du capteur.

### ETAT DE LA TECHNIQUE

Il est connu des capteurs optiques matriciels comprenant une pluralité de détecteurs optoélectroniques élémentaires, couramment appelé pixels, reliés à un circuit de transfert de charges ayant une sortie spatiale.

Un tel capteur optique matriciel permet de déterminer précisément la position du spot laser dans le champ couvert par le capteur optique matriciel mais ne permet pas de déterminer des paramètres temporels associés à l'impulsion laser ayant engendré ce spot laser (durée de l'impulsion laser, période entre deux impulsions laser successives, etc.).

Or, dans certaines applications, les paramètres temporels sont utilisés pour identifier l'émetteur de l'impulsion laser.

Pour obtenir ces paramètres temporels, il a été envisagé d'associer au capteur optique matriciel un capteur mono-élément additionnel externe, tel qu'une photodiode associée à un circuit électronique d'amplification et de seuillage, qui couvre le même champ que le capteur matriciel et qui est dédié à la mesure des paramètres temporels. Cette solution n'est cependant pas optimale.

US 2009/0079956 A1 divulgue un système d'imagerie LADAR 3-D incorporant des couches microélectroniques empilées. Une source lumineuse telle qu'un laser est imagée sur une cible à travers une optique de mise en forme de faisceau. Les photons réfléchis par la cible sont collectés et imagés sur un réseau de détecteurs grâce à une optique de collecte. Les signaux du réseau de détecteurs sont introduits dans un module de traitement multicouche dans lequel chaque couche comprend des circuits de traitement de signal de détecteur. Les signaux du réseau de détecteurs sont amplifiés, comparés à un seuil défini par l'utilisateur, numérisés et introduits dans un registre à décalage FIFO à grande vitesse. En fonction de la valeur du chiffre contenu dans les cases du registre et de l'emplacement de la case du chiffre, le temps de réflexion d'un photon à partir d'une surface cible peut être déterminé.

### OBJET DE L'INVENTION

Un but de l'invention est de fournir des paramètres temporels associés à une impulsion laser ayant engendré un spot laser dans le champ d'un capteur optique matriciel, en plus de la détection de position de ce spot laser dans le champ du capteur optique matriciel.

### BREF EXPOSE DE L'INVENTION

A cet effet, on prévoit, selon l'invention, un dispositif de détection de spot laser, comprenant un capteur optique matriciel ayant une pluralité de détecteurs optoélectroniques élémentaires reliés chacun à un circuit élémentaire de détection d'impulsion, chaque circuit élémentaire de détection d'impulsion comprenant un comparateur pour comparer à un seuil une grandeur électrique fonction d'un courant de sortie du détecteur optoélectronique élémentaire appliquée sur une entrée du comparateur et un module de mémoire reliée à une sortie du comparateur, les modules de mémoire étant reliés à un circuit de multiplexage ayant une sortie formant une sortie spatiale numérique du dispositif de détection de spot laser. Le dispositif de détection de spot laser comporte en outre un circuit OU global ayant des entrées reliées aux sorties des comparateurs et une sortie formant une sortie temporelle numérique en temps réel pour le dispositif de détection de spot laser.

Cette sortie temporelle en temps réel va permettre d'analyser ou de discriminer les impulsions laser reçues avant d'utiliser la sortie spatiale pour la lecture de leurs positions. Le circuit OU global "temps réel", qui remplace le capteur mono-élément additionnel externe, présente un certain nombre d'avantages. Un courant de fond, résultant d'un bruit de fond lumineux, est divisé par le nombre total de détecteurs optoélectroniques élémentaires (pixels) en comparaison avec le capteur mono-élément additionnel externe. De même, la capacité de chacun des détecteurs optoélectroniques élémentaires représentant une surface équivalente à celle du capteur mono-élément additionnel externe est divisée, par rapport à celle du capteur mono-élément additionnel externe, par le nombre total de détecteurs optoélectroniques élémentaires. Le bruit produit par un convertisseur courant-tension de chaque circuit élémentaire de détection d'impulsion est réduit, et une vitesse de réponse dudit convertisseur courant-tension est augmentée. De plus, la mise en œuvre du circuit OU global ne nécessite l'ajout d'aucun composant additionnel et ne requiert pas de mettre en œuvre une voie optique. La sortie temporelle numérique bénéficie par ailleurs des mêmes performances qu'une sortie spatiale classique.

D'autres caractéristiques et avantages de l'invention ressortiront à la lecture de la description qui suit de modes de réalisation particuliers non limitatifs de l'invention.

### BREVE DESCRIPTION DES FIGURES

Il sera fait référence aux dessins annexés, parmi lesquels :
- la figure 1 représente un schéma électrique d'un dispositif de détection de spot laser selon un premier mode de réalisation de l'invention ;
- la figure 2 est un chronogramme représentant des étapes d'un procédé de détection d'un spot laser utilisant le dispositif de détection de spot laser selon l'invention, alors qu'un spot laser cible a été détecté ;
- la figure 3 représente des impulsions laser obtenues par un circuit élémentaire de détection d'impulsion du dispositif de détection de spot laser selon le premier mode de réalisation de l'invention lors de la mise en œuvre du procédé de la figure 2 ;
- les figures 4 et 5 sont des figures analogues à la figure 3, alors qu'un spot laser leurre a été détecté en plus du spot laser cible ;
- la figure 6 est un chronogramme analogue à celui de la figure 2, alors qu'un spot laser leurre a été détecté en plus du spot laser cible ;

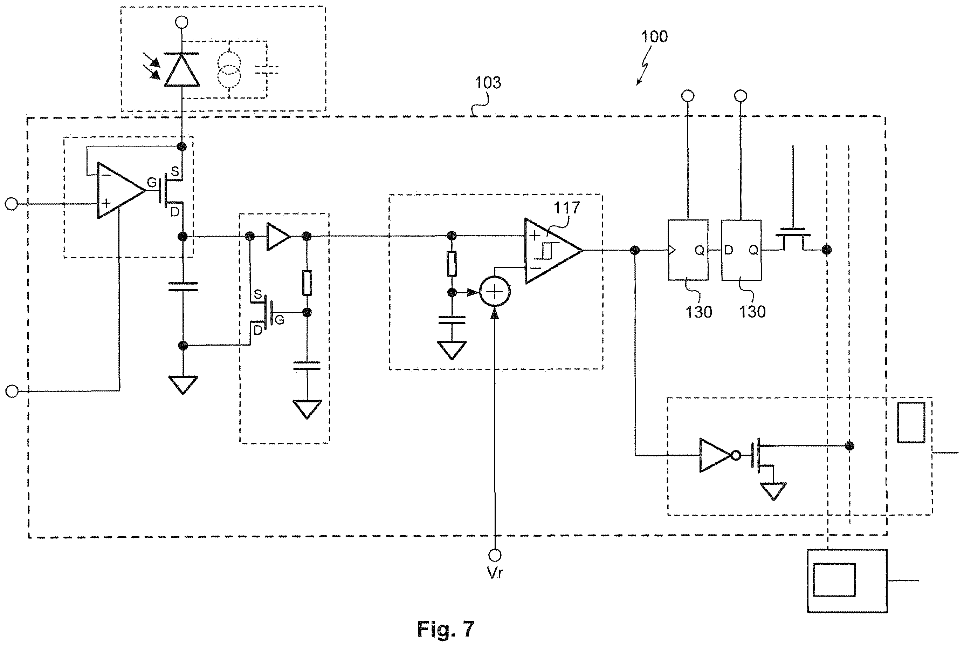

- la figure 7 représente un schéma électrique d'un dispositif de détection de spot laser selon un deuxième mode de réalisation de l'invention.

### DESCRIPTION DETAILLEE DE L'INVENTION

L'invention concerne un dispositif de détection de spot laser destiné à détecter, à identifier et à localiser un spot laser via une détection et une analyse d'impulsions laser ayant engendré le spot laser.

Le dispositif de détection de spot laser selon l'invention peut notamment être intégré dans un système de guidage laser semi-actif (par exemple, pour guider un missile).

On décrit tout d'abord la structure d'un dispositif de détection de spot laser 0 selon un premier mode de réalisation de l'invention.

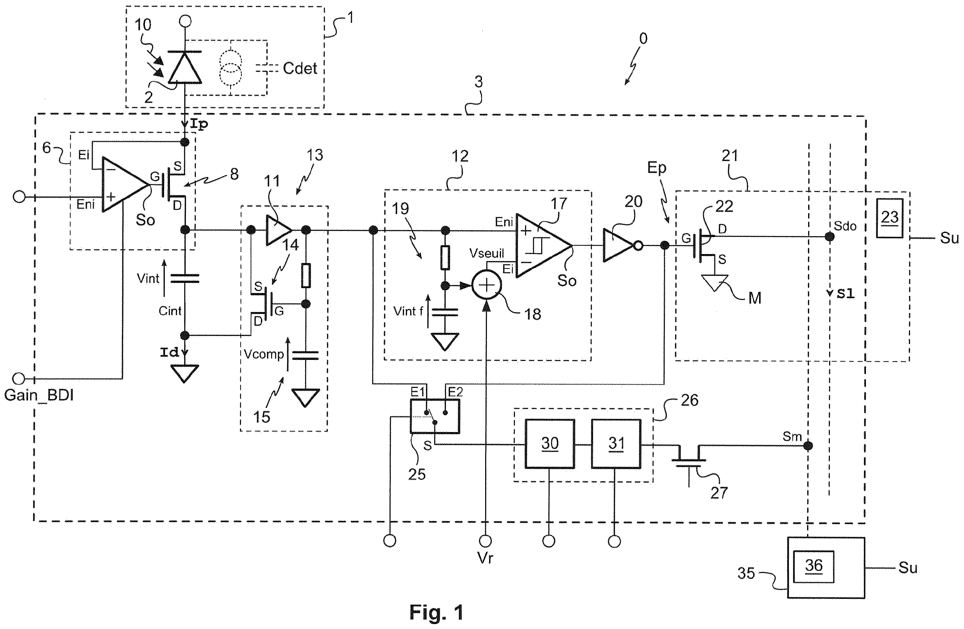

En référence à la figure 1, le dispositif de détection de spot laser 0 comporte un capteur optique matriciel ayant une pluralité de détecteurs optoélectroniques élémentaires 1, couramment appelés pixels, et agencés en lignes et en colonnes. Le dispositif de détection de spot laser 0 comporte aussi des moyens de traitement qui comprennent ici un composant de traitement, en l'occurrence un microcontrôleur (un autre composant de traitement, tel qu'un FPGA, pourrait être utilisé à la place ou en plus du microcontrôleur). Les moyens de traitement gèrent le fonctionnement du dispositif de détection de spot laser 0 et, notamment, acquièrent et analysent les différents signaux produits par les détecteurs optoélectroniques élémentaires 1 du capteur optique matriciel.

Chaque détecteur optoélectronique élémentaire 1 comporte une photodiode 2 qui peut être modélisée par une source de courant en parallèle avec une capacité Cdet.

Les détecteurs optoélectroniques élémentaires 1 sont reliés chacun à un circuit élémentaire de détection d'impulsion 3.

Le circuit élémentaire de détection d'impulsion 3 est un circuit du type à injection directe bufferisée (« Buffered Direct Injection » en anglais).

Le circuit élémentaire de détection d'impulsion 3 comporte ainsi un bloc d'injection directe bufferisée 6 qui comprend un amplificateur 7 et un premier transistor MOSFET 8. Une sortie So de l'amplificateur 7 est connectée à une grille G du premier transistor MOSFET 8. Une entrée inverseuse Ei de l'amplificateur 7 est connectée à une source S du premier transistor MOSFET 8, la source S étant également reliée à l'anode de la photodiode 2.

Le bloc d'injection directe bufferisée 6 met en œuvre un asservissement qui permet de réduire l'impédance d'entrée du premier transistor MOSFET 8 et d'améliorer le contrôle de la polarisation de la photodiode 2. Les variations d'impédance de la capacité Cdet sont ainsi limitées, l'injection de courant est plus efficace et la bande passante de la détection est relativement importante.

Le circuit élémentaire de détection d'impulsion 3 comporte de plus une capacité d'intégration Cint connectée à un drain D du premier transistor MOSFET 8. La capacité d'intégration Cint est adaptée à intégrer un photocourant Ip produit par la photodiode 2 et résultant d'un rayonnement lumineux incident 10 atteignant la photodiode 2.

La valeur de capacité de la capacité d'intégration Cint est nettement inférieure à la valeur de capacité de la capacité Cdet, et donc le gain de conversion courant-tension du circuit élémentaire de détection d'impulsion 3 est relativement important.

On note que le gain de conversion courant-tension est ici un gain variable présentant une dynamique très élevée qui permet d'assurer une détection efficace dans des conditions variables, par exemple entre le début et la fin d'une mission de détection, d'identification et de localisation du spot laser.

La détection d'impulsions laser présentes dans le rayonnement lumineux incident 10 consiste à exploiter, à intervalles réguliers égaux chacun à une période d'intégration prédéterminée, une tension d'intégration Vint aux bornes de la capacité d'intégration Cint. La tension d'intégration Vint résulte de l'intégration du photocourant Ip par la capacité d'intégration Cint. Grâce au gain de conversion courant-tension relativement important évoqué plus tôt, la tension d'intégration Vint est suffisamment élevée pour permettre de détecter la présence ou non, dans le photocourant Ip, d'une impulsion de courant représentative d'une impulsion laser.

L'exploitation de la tension d'intégration Vint consiste à comparer la tension d'intégration Vint aux bornes de la capacité d'intégration Cint avec un seuil de tension de référence Vseuil. La présence, dans le photocourant Ip, d'une impulsion de courant représentative d'une impulsion laser au cours d'une période d'intégration aura en effet pour conséquence d'augmenter légèrement la tension d'intégration Vint, ladite légère augmentation étant détectée par comparaison avec le seuil de tension de référence Vseuil. La comparaison est effectuée par des moyens de comparaison 12 qui seront décrits plus bas.

Cependant, il convient de décharger la capacité d'intégration Cint de manière régulière, pour qu'une augmentation détectée de la tension d'intégration Vint corresponde bien à une impulsion de courant représentative d'une impulsion laser, et non à une accumulation de charges dans la capacité d'intégration Cint résultant de l'intégration du photocourant Ip au cours des périodes d'intégration précédentes.

Le circuit élémentaire de détection d'impulsion 3 comporte à cet effet des moyens de décharge 13 adaptés à décharger la capacité d'intégration Cint de manière continue, c'est-à-dire que les moyens de décharge 13 fonctionnent en permanence et pas uniquement, par exemple, à l'issue d'une période d'intégration.

Les moyens de décharge 13 comportent un deuxième transistor MOSFET 14 dont une source S et un drain D sont connectés aux bornes de la capacité d'intégration Cint et dont une grille G est reliée à un filtre passe-bas de décharge 15. La source S est isolée par un suiveur de tension 11 (qui est un amplificateur d'isolation à forte impédance d'entrée). Le filtre passe-bas de décharge 15 est connecté à la capacité d'intégration Cint. Le filtre passe-bas de décharge 15 est ici un filtre RC.

Le filtre passe-bas de décharge 15 permet de produire une tension de compensation Vcomp. La tension de compensation Vcomp est une composante de la tension Vint qui résulte de la présence d'un courant de bruit de fond dans le photocourant Ip. Le courant de bruit de fond est généré par la photodiode 2 et provient d'un bruit de fond lumineux présent dans le rayonnement lumineux incident 10. La tension de compensation Vcomp correspond à la tension d'intégration Vint à laquelle a été retranchée par le filtre passe-bas de décharge 15 une composante résultant d'une impulsion de courant générée par une impulsion laser.

L'application de la tension de compensation Vcomp sur la grille G du deuxième transistor MOSFET 14 permet de générer un courant de décharge Id proche du courant de bruit de fond qui décharge la capacité d'intégration Cint de manière continue.

On met ainsi en œuvre un filtrage passe-haut en réalisant une « rétro-injection » du courant de décharge Id généré grâce au filtre passe-bas de décharge 15.

Les moyens de décharge 13 permettent donc de décharger automatiquement la capacité d'intégration Cint, mais aussi d'éviter la saturation du bloc d'injection directe bufferisée 6 et de la capacité d'intégration Cint sans avoir besoin, pour éviter cette saturation, de mettre en œuvre une régulation complexe.

Les moyens de comparaison 12 comparent ensuite la tension d'intégration Vint avec le seuil de tension de référence Vseuil. Les moyens de comparaison 12 comportent un comparateur 17, un sommateur 18 et un filtre passe-bas de détection 19. Le filtre passe-bas de détection 19 est ici un filtre RC.

Le filtre passe-bas de détection 19 filtre le signal Vint en sortie du suiveur de tension 11 et est destiné à filtrer la tension d'intégration Vint pour obtenir une tension d'intégration Vintf filtrée de ses composantes résultant d'impulsions lumineuses à haute fréquence.

La tension d'intégration filtrée Vintf, tout comme la tension de compensation Vcomp, correspond donc à la tension d'intégration Vint à laquelle a été retranchée une composante résultant d'une impulsion de courant générée par une impulsion laser.

Le sommateur 18 ajoute à la tension d'intégration filtrée Vintf un seuil de tension réglable Vr pour obtenir le seuil de tension de référence Vseuil. Le seuil de tension réglable Vr est réglable extérieurement et collectivement pour l'ensemble des pixels de la matrice de détection. Le seuil de tension réglable Vr est réglé de sorte que, pour chaque pixel, le seuil de tension de référence Vseuil soit suffisamment au-dessus du niveau du bruit de fond pour éviter de générer de fausses alarmes. Le seuil de tension réglable Vr est réglé grâce à une tension de réglage unique pour tous les pixels, soit une fois, par essai, au moment de la mise au point de la matrice de détection, soit de manière continue par les moyens de traitement du dispositif de détection de spot laser 0.

Ainsi, le seuil de tension de référence Vseuil est un seuil auto-adaptatif qui dépend du niveau du bruit de fond lumineux présent dans le rayonnement lumineux incident 10.

La tension d'intégration Vint est appliquée sur une entrée non inverseuse Eni du comparateur 17. Le seuil de tension de référence Vseuil est appliqué sur une entrée inverseuse Ei du comparateur 17. Le comparateur 17 compare la tension d'intégration Vint avec le seuil de tension de référence Vseuil.

Lorsque la tension d'intégration Vint est supérieure au seuil de tension de référence Vseuil, le comparateur produit sur sa sortie So un signal numérique égal à « 1 ». Lorsque la tension d'intégration Vint est inférieure ou égale au seuil de tension de référence Vseuil, le comparateur produit sur sa sortie So un signal numérique égal à « 0 ».

Le circuit élémentaire de détection d'impulsion 3 comporte de plus une porte NON 20, qui est reliée à la sortie du comparateur 17. Lorsque le comparateur 17 produit sur sa sortie So un signal numérique égal à 1, la sortie de la porte NON 20 est à 0, et lorsque le comparateur 17 produit sur sa sortie So un signal numérique égal à 0, la sortie de la porte NON 20 est à 1.

Le dispositif de détection de spot laser 0 comporte en outre un circuit OU global 21.

Le circuit OU global 21 possède une pluralité d'entrées Ep et une sortie unique Su, et comporte une pluralité de troisièmes transistors MOSFET 22 « en drain ouvert » ainsi que des composants additionnels 23.

Chaque entrée Ep du circuit OU global 21 est reliée à la sortie de la porte NON 20 d'un circuit élémentaire de détection d'impulsion 3.

Chaque troisième transistor MOSFET 22 est situé dans un circuit élémentaire de détection d'impulsion 3.

Dans chaque circuit élémentaire de détection d'impulsion 3, la sortie de la porte NON 20 est reliée à une grille G du troisième transistor MOSFET 22. Une source S du troisième transistor MOSFET 22 est reliée à une masse M du circuit élémentaire de détection d'impulsion 3. Un drain D du troisième transistor MOSFET 22 forme une sortie en drain ouvert Sdo du circuit élémentaire de détection d'impulsion 3.

Toutes les sorties en drain ouvert Sdo (et donc tous les drains D des troisièmes transistors MOSFET 22) des circuits élémentaires de détection d'impulsion 3, eux-mêmes reliés à des détecteurs optoélectroniques élémentaires 1 situés sur une même ligne du capteur matriciel, sont reliées entre elles pour additionner lesdites sorties en drain ouvert Sdo et former ainsi un signal de ligne Sl.

Les composants additionnels 23 du circuit OU global 21 sont agencés pour buffériser à leur tour chaque signal de ligne Sl, pour additionner l'ensemble des signaux de ligne Sl, et pour appliquer le signal résultant sur la sortie unique Su du circuit OU global 21.

La sortie unique Su du circuit OU global 21 constitue donc une sortie temporelle numérique du dispositif de détection de spot laser 0.

Chaque circuit élémentaire de détection d'impulsion 3 comporte de plus un sélecteur 25, un module de mémoire 26 et un quatrième transistor MOSFET 27.

Le module de mémoire 26 comprend ici une première mémoire 30 et une deuxième mémoire 31. La première mémoire 30 et la deuxième mémoire 31 comportent ici chacune un composant échantillonneur-bloqueur.

Le sélecteur 25 possède une première entrée E1, une deuxième entrée E2 et une sortie S. Le sélecteur 25 est commandé par les moyens de traitement du dispositif de détection de spot laser 0.

La première entrée E1 du sélecteur 25 est reliée à l'entrée non inverseuse Eni du comparateur 17, sur laquelle est appliquée la tension d'intégration Vint, qui est une tension analogique représentative d'impulsions de courant provenant des impulsions laser. On parlera dans la suite de cette description d'« impulsions laser analogiques » pour désigner la tension analogique représentative d'impulsions de courant provenant des impulsions laser détectées par le dispositif de détection de spot laser 0.

La deuxième entrée E2 du sélecteur 25 est quant à elle reliée à la porte NON 20 elle-même reliée à la sortie So du comparateur 17, sur laquelle est générée un signal numérique représentatif de la présence (ou de l'absence) d'impulsions laser. On parlera dans la suite de cette description d'« impulsions laser numérisées » pour désigner le signal numérique représentatif de la présence (ou de l'absence) d'impulsions laser.

La sortie S du sélecteur 25 est reliée à une entrée de la première mémoire 30. Ainsi, le sélecteur 25 peut être commandé par les moyens de traitement du dispositif de détection de spot laser 0 pour sélectivement relier l'entrée non inverseuse Eni du comparateur 17 à l'entrée de la première mémoire 30, ou la sortie So du comparateur 17 à l'entrée de la première mémoire 30.

Une sortie de la première mémoire 30 est reliée à une entrée de la deuxième mémoire 31.

Ainsi, lorsque la valeur mémorisée par la deuxième mémoire 31 est en train d'être lue, la première mémoire 30 est disponible pour mémoriser une nouvelle valeur.

La sortie de la deuxième mémoire 31 est reliée au quatrième transistor MOSFET 27 qui lui-même est relié à une sortie mixte Sm du circuit élémentaire de détection d'impulsion 3.

L'ensemble des sorties mixtes Sm des circuits élémentaires de détection d'impulsion 3 reliés à l'ensemble des détecteurs optoélectroniques élémentaires 1 de chaque ligne et de chaque colonne du capteur matriciel est relié à un circuit de multiplexage 35.

Le circuit de multiplexage 35 comporte un amplificateur 36 et une sortie unique Su reliée à une broche unique connectée à l'amplificateur 36, qui constitue ainsi une sortie spatiale numérique du dispositif de détection de spot laser 0 lorsque le sélecteur 25 est commandé pour relier la sortie So du comparateur 17 à l'entrée de la première mémoire 30, ou bien qui constitue une sortie spatiale analogique du dispositif de détection de spot laser 0 lorsque le sélecteur 25 est commandé pour relier l'entrée non inverseuse Eni du comparateur 17 à l'entrée de la première mémoire 30.

On note ici que les deux échantillonneurs-bloqueur de la première mémoire 30 et de la deuxième mémoire 31, qui forment chacun une mémoire « 1 bit », présentent un encombrement inférieur à celui que représenterait une double mémoire « 1 bit » nécessaire si chaque circuit élémentaire de détection d'impulsion 3 comportait une sortie numérique et une sortie analogique distinctes (et non une sortie mixte analogique ou numérique en fonction de la commande du sélecteur 25).

On décrit maintenant le rôle joué par la sortie temporelle numérique, la sortie spatiale numérique et la sortie spatiale analogique du dispositif de détection de spot laser 0.

La sortie temporelle numérique permet d'effectuer en temps réel et en continu une analyse temporelle des impulsions laser numérisées. Cette analyse temporelle des impulsions laser numérisées est ici effectuée par le microcontrôleur des moyens de traitement du dispositif de détection de spot laser 0.

L'analyse temporelle consiste à vérifier si la largeur d'une impulsion laser numérisée et si la durée entre deux impulsions laser numérisées successives sont conformes à celles attendues.

Cette analyse temporelle permet de distinguer des impulsions laser numérisées valides et des impulsions laser numérisées non valides.

Les impulsions laser numérisées valides correspondent à des impulsions laser générant un spot dit « spot laser cible ». Un spot laser cible est un spot laser généré par un « allié » de l'utilisateur du dispositif de détection de spot laser 0, que celui-ci vise justement à détecter.

Les impulsions laser numérisées parasites correspondent quant à elles à des échos du spot laser cible, à des éclats spéculaires, à une rétrodiffusion du spot laser cible en fin de trajectoire dans l'atmosphère, ou bien encore à un spot dit « spot laser leurre ». Un spot laser leurre est un spot généré non pas par un allié mais par un ennemi de l'utilisateur du dispositif de détection de spot laser 0, qui vise à simuler un spot laser cible pour tromper ledit utilisateur.

Lorsque la largeur d'une impulsion laser numérisée et la durée entre deux impulsions numérisées successives sont conformes à celles attendues, les moyens de traitement (microcontrôleur ou FPGA) du dispositif de détection de spot laser 0 génèrent une image spatiale et lisent ladite image spatiale.

La sortie spatiale numérique et la sortie spatiale analogique peuvent toutes les deux êtres utilisées pour représenter spatialement le ou les pixels qui ont détecté une ou des impulsions laser, et donc pour générer l'image spatiale qui permet de déterminer la position d'un ou de plusieurs spots lasers qui ont été détectés par le dispositif de détection de spot laser 0.

La sortie spatiale numérique produit une image spatiale numérique des pixels, alors que la sortie spatiale analogique produit une image spatiale analogique des pixels.

La sortie spatiale analogique permet aussi, lorsque plusieurs impulsions laser numérisées présentent une largeur conforme et une durée conforme entre deux impulsions numérisées successives, d'effectuer une discrimination par radiométrie permettant de distinguer des impulsions laser numérisées valides et des impulsions laser numérisées parasites.

On notera qu'il est possible d'utiliser les doubles échantillonneurs bloqueurs pour mémoriser les impulsions laser soit en numérique soit en analogique, donc avec le même circuit pour les deux types.

On illustre maintenant, grâce à un premier exemple concret et à un deuxième exemple concret, la mise en œuvre d'un procédé de détection d'un spot laser par un dispositif de détection d'un spot laser 0.

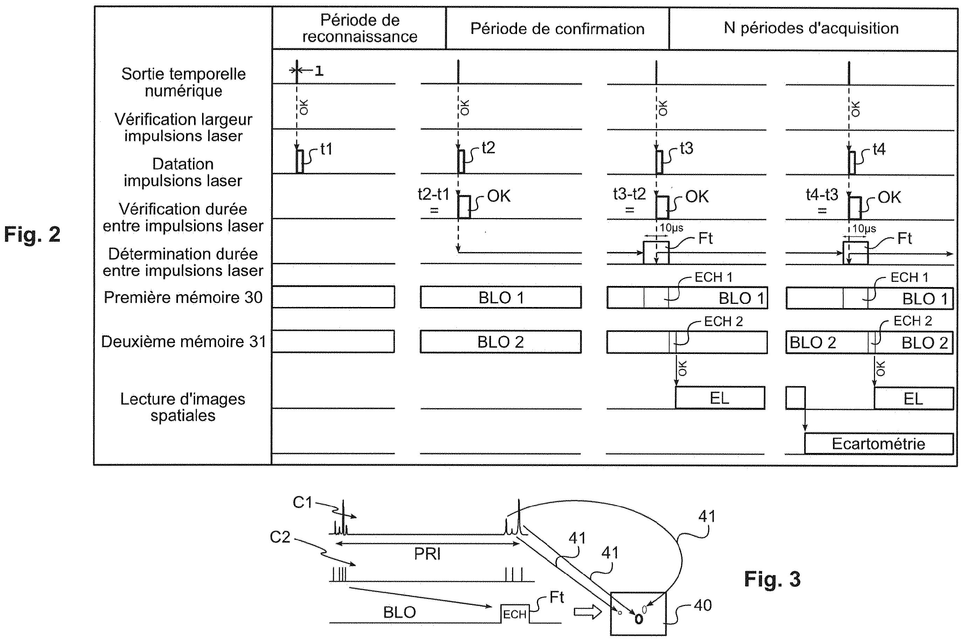

Le premier exemple concret est illustré en référence aux figures 2 et 3.

La mise en œuvre du procédé de détection comporte tout d'abord une période de reconnaissance, au cours de laquelle le dispositif de détection de spot laser 0 détecte une impulsion numérisée sur la sortie temporelle numérique. La largeur l de l'impulsion numérisée est vérifiée et correspond bien ici à la largeur d'une impulsion laser susceptible d'avoir généré le spot laser cible. Le moment de la survenue de l'impulsion laser numérisée est daté et prend la date t1.

Puis, une impulsion numérisée suivante est détectée, et la largeur de l'impulsion numérisée suivante est vérifiée. Le moment de la survenue de l'impulsion numérisée suivante est daté et prend la date t2.

La durée t2-t1 est calculée. La durée t2-t1 correspond bien à une valeur d'intervalle de répétition PRI (pour « Pulse Repetition Interval ») associée au spot laser cible. On notera donc que t2-t1 = PRI.

La mise en œuvre du procédé de détection comporte ensuite une période de confirmation. Le dispositif de détection de spot laser selon l'invention tente de détecter des impulsions laser numérisées au temps t3 tel que t3-t2 = t2-t1 = PRI.

Une impulsion laser numérisée au temps t3 est bien détectée. La largeur de l'impulsion laser numérisée au temps t3 est vérifiée et correspond bien, à nouveau, à la largeur d'une impulsion laser susceptible d'avoir généré le spot laser cible.

Suite à ces différentes vérifications, l'acquisition d'images spatiales peut débuter. La mise en œuvre du procédé de détection comporte donc une succession d'un nombre « N » de périodes d'acquisition d'images spatiales.

En référence à la figure 3, à chaque instant tn (ici, N ≥ n ≥ 3), un groupe d'impulsions laser analogiques est présent sur la sortie spatiale analogique (courbe C1 de la figure 3), qui correspond à un groupe d'impulsions laser numérisées sur la sortie temporelle numérique (courbe C2 de la figure 3).

Chaque groupe d'impulsions laser analogiques comporte une pluralité de pics parmi lesquels certains sont attribuables à des échos ou à une rétrodiffusion du spot laser cible en fin de trajectoire dans l'atmosphère.

La sortie spatiale analogique est utilisée pour distinguer les différents pics par radiométrie et pour positionner les différents pics pour produire l'image spatiale 40. Sur la figure 3, les flèches 41 désignent la position de chaque pic sur l'image spatiale 40 correspondante.

Le pic correspondant à l'impulsion laser ayant généré le spot laser cible est ici celui dont l'amplitude est la plus importante.

Les moyens de traitement du dispositif de détection de spot laser 0 acquièrent les amplitudes des pics des groupes d'impulsions laser analogiques par intégration grâce à un échantillonnage ECH réalisé au cours de fenêtres temporelles Ft dont la largeur, au moment tn, est déterminée au moment tn-1, la durée entre le moment tn-1 et le moment tn étant égale à PRI.

Ici, la largeur d'une fenêtre temporelle Ft est typiquement de 10µs, pour tenir compte d'une gigue (ou « jitter » en anglais) maximale de +/-5µs qui correspond à une valeur classique de gigue maximale dans un illuminateur de type STANAG 3733.

Si l'analyse de la sortie temporelle numérique montre, au moment tn-1, que le groupe d'impulsions laser s'étend sur une durée supérieure à la largeur de la fenêtre temporelle Ft, la fenêtre temporelle Ft au temps tn sera adaptée en conséquence pour bien tenir compte de l'ensemble des pics.

Avant l'échantillonnage correspondant à un moment tn quelconque, l'échantillonneur-bloqueur de la première mémoire 30 est en mode de blocage BLO1 et l'échantillonneur-bloqueur de la deuxième mémoire 31 est en mode de blocage BLO2 (c'est à dire que la première mémoire 30 et la deuxième mémoire 31 sont en état permanent de remise à zéro).

Puis, au moment de la survenue du groupe d'impulsions laser, l'échantillonneur-bloqueur de la première mémoire 30 passe en mode d'échantillonnage ECH1 pendant la durée de la fenêtre temporelle Ft.

La deuxième mémoire 31 passe alors à son tour en mode d'échantillonnage ECH2, et la valeur mémorisée dans la première mémoire 30 est transférée très rapidement à la deuxième mémoire 31. La deuxième mémoire 31 est alors utilisée pour la lecture d'une image spatiale correspondant au temps tn. La première mémoire 30 redevient disponible pour l'intégration suivante et donc pour la production d'une image spatiale suivante correspondant au temps tn+1.

Les moyens de traitement du dispositif de détection de spot laser 0 lisent séquentiellement les deuxièmes mémoires 31 de l'ensemble des circuits élémentaires de détection d'impulsion 3 au cours d'une étape de lecture EL, de manière à produire une image spatiale complète correspondant au temps tn. Le procédé est répété pour l'ensemble des temps tn correspondant par exemple à la durée d'une mission.

Deux images spatiales successives (c'est-à-dire correspondant à des images spatiales au temps tn-1 et au temps tn) sont par ailleurs utilisées pour mettre en œuvre une estimation d'écartométrie.

Le deuxième exemple concret concerne un cas plus complexe, dans lequel deux détecteurs optoélectroniques élémentaires 1 (deux pixels) du dispositif de détection de spot laser 0 détectent des impulsions laser telles qu'une durée entre deux impulsions laser successives soit conforme à une durée attendue.

Les impulsions laser détectées sont des impulsions ayant engendré un spot laser cible et des impulsions ayant engendré un spot laser leurre.

Deux cas de figure se présentent alors.

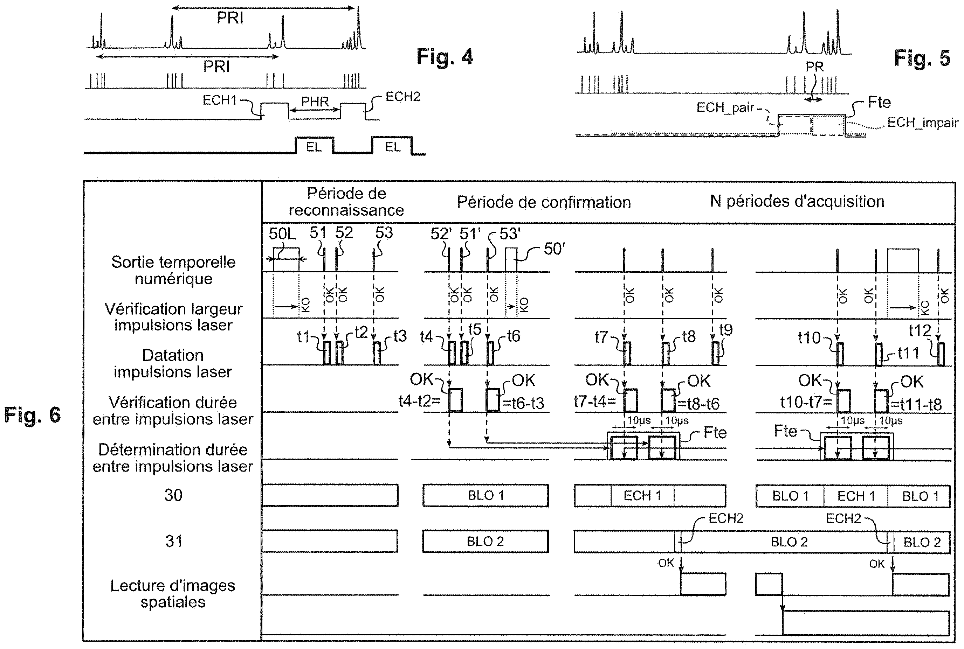

Dans un premier cas de figure, représenté sur la figure 4, la phase relative PHR des impulsions laser, c'est-à-dire la durée entre deux impulsions laser numérisées successives correspondant l'une au spot laser cible et l'autre au spot laser leurre, présente une durée supérieure à la durée d'une étape de lecture EL.

Ainsi, la durée entre deux groupes d'impulsions laser numérisées successives (ou, plus exactement, la durée entre deux fenêtres temporelles Ft successives utilisées l'une pour intégrer les pics du groupe d'impulsions correspondant au spot laser cible et l'autre pour intégrer les pics du groupe d'impulsions correspondant au spot laser leurre) est suffisamment importante pour permettre de lire une image spatiale complète.

Dans ce cas, le dispositif de détection de spot laser 0 a le temps, entre deux échantillonnages distincts ECH1 et ECH2, de lire les deuxièmes mémoires 31 des circuits élémentaires de détection d'impulsion 3 de l'ensemble des détecteurs optoélectroniques élémentaires 1, de manière à déterminer à quels détecteurs optoélectroniques élémentaires 1 correspondent les impulsions numérisées laser. Le dispositif de détection de spot laser 0 reproduit et lit ainsi une image spatiale complète valide.

Dans un deuxième cas de figure, représenté sur la figure 5, la phase relative PR des impulsions numérisées, c'est-à-dire la durée entre deux impulsions laser successives correspondant l'une au spot laser cible et l'autre au spot laser leurre, ne permet pas la lecture d'une image spatiale complète.

Plusieurs solutions sont alors envisageables.

La première solution consiste à utiliser une fenêtre temporelle élargie Fte pour inclure les impulsions laser dans une seule et même image spatiale. Le dispositif de détection de spot laser 0 utilise alors la sortie spatiale analogique et met en œuvre une analyse par radiométrie, ou bien utilise la cohérence spatiale des trajectoires pour associer les impulsions laser aux pixels correspondant et produire une image spatiale complète valide.

La seconde solution consiste à alterner la mise en œuvre de l'échantillonnage entre les circuits élémentaires de détection d'impulsion 3 des deux détecteurs optoélectroniques élémentaires 1 concernés.

Ainsi, aux temps tn tels que n est pair (c'est-à-dire que tn correspond à un multiple pair de PRI), un échantillonnage ECH_pair est réalisé dans le circuit élémentaire de détection 3 relié à l'un des deux détecteurs optoélectroniques élémentaires 1 concernés, et aux temps tn tels que n est impair (c'est-à-dire que tn correspond à un multiple impair de PRI), un échantillonnage ECH_impair est réalisé dans le circuit élémentaire de détection d'impulsion 3 relié à l'autre des deux détecteurs optoélectroniques élémentaires 1 concernés. La sortie des circuits élémentaires de détection d'impulsion 3 de chaque détecteur optoélectronique élémentaire 1 concernée n'est donc lue qu'une PRI sur deux. Si les deux détecteurs optoélectroniques élémentaires 1 sont suffisamment éloignés dans l'image spatiale, le dispositif de détection de spot laser 0 pourra mettre en œuvre un échantillonnage sur une fenêtre temporelle élargie Fte et discriminer les deux détecteurs optoélectroniques élémentaires 1 concernés grâce à leur séparation spatiale.

Enfin, lorsque le dispositif de détection de spot laser 0 aura déterminé le détecteur optoélectronique élémentaire 1 ayant détecté l'impulsion laser valide, le dispositif de détection de spot laser 0 pourra se contenter de mettre en œuvre un échantillonnage uniquement dans le circuit élémentaire de détection d'impulsion 3 de ce détecteur optoélectronique élémentaire 1.

Si le spot laser leurre est parfaitement synchronisé avec le spot laser cible, il peut être impossible de séparer temporellement les deux échantillonnages. On met alors en œuvre un échantillonnage sur une fenêtre temporelle élargie Fte. Les impulsions laser sont intégrées dans une seule et même image spatiale. Le dispositif de détection de spot laser 0 utilise alors la sortie spatiale analogique et met en œuvre une analyse par radiométrie ou bien utilise la cohérence spatiale des trajectoires pour associer les impulsions laser aux pixels correspondant et produire une image spatiale valide.

La première solution est illustrée sur le chronogramme de la figure 6.

La mise en œuvre du procédé de détection comporte tout d'abord une période de reconnaissance au cours de laquelle le dispositif de détection de spot laser 0 détecte, grâce à la sortie temporelle numérique, une première impulsion numérisée 50, une deuxième impulsion numérisée 51, une troisième impulsion numérisée 52 et une quatrième impulsion numérisée 53.

La largeur de chaque impulsion numérisée laser est vérifiée.

La largeur L de la première impulsion laser numérisée 50 est trop importante et ne correspond pas à la largeur d'une impulsion laser numérisée susceptible d'avoir généré le spot laser cible. La première impulsion laser numérisée 50 correspond à un éclat spéculaire et est écartée.

La largeur de la deuxième impulsion laser numérisée 51, de la troisième impulsion laser numérisée 52 et de la quatrième impulsion laser numérisée 53 correspondent bien à la largeur d'une impulsion laser numérisée susceptible d'avoir généré le spot laser cible.

Le moment de la survenue de la deuxième impulsion laser numérisée 51 est daté et prend la date t1. Le moment de la survenue de la troisième impulsion laser numérisée 52 est daté et prend la date t2. Le moment de la survenue de la quatrième impulsion laser numérisée 53 est daté et prend la date t3.

Puis, des impulsions numérisées suivantes sont détectées.

La deuxième impulsion laser numérisée suivante 51' est datée et prend la date t5.

La troisième impulsion laser numérisée suivante 52' est datée et prend la date t4 (elle survient avant la deuxième impulsion laser numérisée suivante 51').

La quatrième impulsion laser numérisée suivante 53' est datée et prend la date t6.

La durée entre la deuxième impulsion laser 51 et la deuxième impulsion laser suivante 51' ne correspond pas à une valeur d'intervalle de répétition PRI associée au spot laser cible. La deuxième impulsion laser 51 et la deuxième impulsion laser suivante 51' (et les deuxièmes impulsions laser suivantes) ne correspondent pas à un spot laser cible.

La durée entre la troisième impulsion laser 52 et la troisième impulsion laser suivante 52' correspond bien à une valeur d'intervalle de répétition PRI associée au spot laser cible.

La durée entre la quatrième impulsion laser 53 et la quatrième impulsion laser suivante 53' correspond bien à une valeur d'intervalle de répétition PRI associée au spot laser cible.

On voit bien que la durée entre une troisième impulsion laser et une quatrième impulsion laser successives ne permet pas la lecture d'une image.

Une fenêtre temporelle élargie Fte est donc utilisée pour inclure les impulsions laser dans une seule et même image spatiale.

Le dispositif de détection de spot laser 0 utilise alors la sortie spatiale analogique et met en œuvre une analyse par radiométrie ou bien utilise la cohérence spatiale des trajectoires pour associer les impulsions laser aux pixels correspondant et produire une image spatiale valide.

Bien entendu, l'invention n'est pas limitée au mode de réalisation décrit mais englobe toute variante entrant dans le champ de l'invention telle que définie par les revendications.

En référence à la figure 8, chaque circuit élémentaire de détection d'impulsion 103 peut parfaitement comporter, à la place du sélecteur 25 et du module de mémoire 26 précédemment décrits, deux mémoires 130 « 1 bit » connectées en série à la sortie du comparateur 117. Dans ce cas, le circuit élémentaire de détection d'impulsion 103 ne comporte pas de sortie mixte mais une sortie numérique uniquement, et le dispositif de détection de spot laser 100 comporte uniquement une sortie spatiale numérique (et pas de sortie spatiale analogique).

Chaque circuit élémentaire de détection d'impulsion comporte une « sortie en drain ouvert » mise en œuvre grâce à un transistor MOSFET. Le terme « sortie en drain ouvert » couvre ici une sortie similaire mise en œuvre par un transistor différent (par exemple, une sortie collecteur ouvert utilisant un transistor bipolaire).

Dans cette description, le terme « circuit » doit être compris comme étant un ensemble de composants reliés entre eux, lesdits composants n'étant pas nécessairement montés sur une carte électrique distincte.

## Revendications

1. Dispositif de détection de spot laser (0 ; 100), comprenant un capteur optique matriciel ayant une pluralité de détecteurs optoélectroniques élémentaires (1) reliés chacun à un circuit élémentaire de détection d'impulsion (3 ; 103), chaque circuit élémentaire de détection d'impulsion comprenant un comparateur pour comparer à un seuil une grandeur électrique fonction d'un courant de sortie du détecteur optoélectronique élémentaire appliquée sur une entrée du comparateur et un module de mémoire (26) reliée à une sortie du comparateur, les modules de mémoire étant reliés à un circuit de multiplexage (35) ayant une sortie formant une sortie spatiale numérique du dispositif de détection de spot laser, **caractérisé en ce que** le dispositif de détection de spot laser comporte en outre un circuit OU global (21) ayant des entrées reliées aux sorties des comparateurs et ayant une sortie formant une sortie temporelle numérique en temps réel du dispositif de détection de spot laser.

2. Dispositif selon la revendication 1, dans lequel le circuit OU global (21) comporte une pluralité de transistors en drain ouvert (22), chaque transistor en drain ouvert étant relié à une sortie d'un comparateur d'un des circuits élémentaires de détection d'impulsion et formant une sortie en drain ouvert de ce circuit élémentaire de détection d'impulsion.

3. Dispositif selon la revendication 2, dans lequel les sorties en drain ouvert de circuits élémentaires de détection d'impulsion reliés à des détecteurs optoélectroniques élémentaires situés sur une même ligne du capteur matriciel sont reliées entre elles pour additionner lesdites sorties en drain ouvert et former ainsi un signal de ligne (Sl).

4. Dispositif selon la revendication 3, dans lequel le circuit OU global comporte en outre des composants agencés pour additionner entre eux les signaux de ligne et former ainsi la sortie temporelle du dispositif de détection de spot laser (0 ; 100).

5. Dispositif selon l'une des revendications précédentes, dans lequel une entrée du comparateur de chaque circuit élémentaire de détection d'impulsion est reliée au module mémoire, et dans lequel la sortie du circuit de multiplexage forme aussi une sortie spatiale analogique du dispositif de détection.

6. Dispositif selon la revendication 5, dans lequel chaque module de mémoire comporte une première mémoire (30) et une deuxième mémoire (31).

7. Dispositif selon la revendication 6, dans lequel chaque circuit élémentaire de détection d'impulsion comporte en outre un sélecteur ayant pour entrées l'entrée du comparateur et la sortie du comparateur et ayant une sortie reliée à la première mémoire et à la deuxième mémoire.

8. Dispositif selon la revendication 6, dans lequel la première mémoire (30) et/ou la deuxième mémoire (31) comportent un échantillonneur-bloqueur.

9. Procédé de détection d'un spot laser mis en œuvre par un dispositif de détection de spot laser selon l'une des revendications précédentes, le procédé de détection d'un spot laser comportant une étape de vérification au cours de laquelle la sortie temporelle du dispositif de détection de spot laser est utilisée pour déterminer une durée d'une impulsion laser et/ou une durée entre deux impulsions laser successives.

10. Procédé de détection selon la revendication 9, dans lequel la durée d'une impulsion laser et/ou la durée entre deux impulsions laser successives sont utilisées pour vérifier que l'impulsion laser correspond bien à un spot laser cible.

11. Procédé selon la revendication 9, le dispositif étant pourvu d'une sortie spatiale analogique, la sortie spatiale analogique est utilisée, lorsque plusieurs impulsions laser numérisées présentent une largeur conforme et une durée conforme entre deux impulsions numérisées successives, pour effectuer une discrimination par radiométrie permettant de distinguer des impulsions laser numérisées valides et des impulsions laser numérisées parasites.

12. Procédé selon la revendication 9, chaque module de mémoire comportant une première mémoire (30) et une deuxième mémoire (31) comportant chacune un échantillonneur-bloqueur, chaque circuit élémentaire de détection d'impulsion comportant en outre un sélecteur ayant pour entrées l'entrée du comparateur et la sortie du comparateur et ayant une sortie reliée à la première mémoire et à la deuxième mémoire, les échantillonneurs-bloqueurs étant commandés pour mémoriser les impulsions laser soit en numérique soit en analogique.

## Patentansprüche

1. Vorrichtung (0; 100) zum Erkennen eines Laserflecks, umfassend einen optischen Matrixsensor mit einer Vielzahl von elementaren optoelektronischen Detektoren (1), die jeweils mit einer elementaren Impulsdetektionsschaltung (3; 103) verbunden sind, wobei jede elementare Impulsdetektionsschaltung einen Komparator umfasst, um eine elektrische Größe, die von einem Ausgangsstrom des elementaren optoelektronischen Detektors abhängt und die an einem Eingang des Komparators angelegt wird, mit einem Schwellenwert zu vergleichen, sowie ein Speichermodul (26), das mit einem Ausgang des Komparators verbunden ist, wobei die Speichermodule mit einer Multiplexerschaltung (35) verbunden sind, die einen Ausgang hat, der einen digitalen räumlichen Ausgang der Vorrichtung zum Erkennen des Laserflecks bildet, **dadurch gekennzeichnet, dass** die Vorrichtung zum Erkennen des Laserflecks ferner eine globale ODER-Schaltung (21) umfasst, die Eingänge hat, die mit den Ausgängen der Komparatoren verbunden sind, und einen Ausgang, der einen digitalen zeitlichen Echtzeit-Ausgang der Vorrichtung zum Erkennen des Laserflecks bildet.

2. Vorrichtung nach Anspruch 1, bei der die globale ODER-Schaltung (21) eine Vielzahl von Open-Drain-Transistoren (22) umfasst, wobei jeder Open-Drain-Transistor mit einem Ausgang eines Komparators einer der elementaren Impulsdetektionsschaltungen verbunden ist und einen Open-Drain-Ausgang dieser elementaren Impulsdetektionsschaltung bildet.

3. Vorrichtung nach Anspruch 2, bei der die Open-Drain-Ausgänge der elementaren Impulsdetektionsschaltungen, die mit den elementaren optoelektronischen Detektoren verbunden sind, die sich auf einer selben Leitung des Matrixsensors befinden, miteinander verbunden sind, um diese Open-Drain-Ausgänge zu addieren und so ein Leitungssignal (S1) zu bilden.

4. Vorrichtung nach Anspruch 3, bei der die globale ODER-Schaltung ferner Komponenten umfasst, die ausgebildet sind, um die Leitungssignale miteinander zu addieren und so den zeitlichen Ausgang der Vorrichtung (0; 100) zum Erkennen des Laserflecks zu bilden.

5. Vorrichtung nach einem der vorhergehenden Ansprüche, bei der ein Eingang des Komparators jeder elementaren Impulsdetektionsschaltung mit dem Speichermodul verbunden ist, und bei der der Ausgang der Multiplexerschaltung auch einen analogen räumlichen Ausgang der Vorrichtung zum Erkennen bildet.

6. Vorrichtung nach Anspruch 5, bei der jedes Speichermodul einen ersten Speicher (30) und einen zweiten Speicher (31) umfasst.

7. Vorrichtung nach Anspruch 6, bei der jede elementare Impulsdetektionsschaltung ferner einen Selektor umfasst, der als Eingänge den Eingang des Komparators und den Ausgang des Komparators hat, und der einen Ausgang hat, der mit dem ersten Speicher und mit dem zweiten Speicher verbunden ist.

8. Vorrichtung nach Anspruch 6, bei der der erste Speicher (30) und/oder der zweite Speicher (31) ein Abtast- und Halte-Glied umfassen.

9. Verfahren zum Erkennen eines Laserflecks, das von einer Vorrichtung zum Erkennen eines Laserflecks nach einem der vorhergehenden Ansprüche durchgeführt wird, wobei das Verfahren zum Erkennen eines Laserflecks einen Schritt des Verifizierens umfasst, während dem der zeitliche Ausgang der Vorrichtung zum Erkennen des Laserflecks verwendet wird, um eine Dauer eines Laserimpulses und/oder eine Dauer zwischen zwei aufeinanderfolgenden Laserimpulsen zu bestimmen.

10. Verfahren zum Erkennen nach Anspruch 9, bei dem die Dauer eines Laserimpulses und/oder die Dauer zwischen zwei aufeinanderfolgenden Laserimpulsen verwendet werden, um zu verifizieren, dass der Laserimpuls tatsächlich einem Ziel-Laserfleck entspricht.

11. Verfahren nach Anspruch 9, wobei, unter Berücksichtigung, dass die Vorrichtung mit einem analogen räumlichen Ausgang versehen ist, der analoge räumliche Ausgang verwendet wird, wenn mehrere digitale Laserimpulse eine konforme Breite und eine konforme Dauer zwischen zwei aufeinanderfolgenden digitalen Impulsen aufweisen, um eine Diskrimination durch Radiometrie vorzunehmen, die ein Unterscheiden von gültigen digitalen Laserimpulsen und parasitären digitalen Laserimpulsen ermöglicht.

12. Verfahren nach Anspruch 9, wobei jedes Speichermodul einen ersten Speicher (30) und einen zweiten Speicher (31) umfasst, die jeweils ein Abtast- und Halte-Glied umfassen, wobei jede elementare Impulsdetektionsschaltung ferner einen Selektor umfasst, der als Eingänge den Eingang des Komparators und den Ausgang des Komparators hat und der einen Ausgang hat, der mit dem ersten Speicher und mit dem zweiten Speicher verbunden ist, wobei die Abtast- und Halte-Glieder gesteuert werden, um die Laserimpulse sowohl digital als auch analog zu speichern.

## Claims

1. A laser spot detecting device (0; 100), comprising a matrix optical sensor having a plurality of elementary optoelectronic detectors (1) each connected to a pulse detecting elementary circuit (3; 103), with each pulse detecting elementary circuit comprising a comparator for comparing with a threshold an electrical quantity depending on an output current of the elementary optoelectronic detector applied to an input of the comparator and a memory module (26) connected to an output of the comparator, with the memory modules being connected to a multiplexing circuit (35) having an output forming a digital spatial output of the laser spot detecting device, **characterized in that** the laser spot detecting device further comprises a global OR circuit (21) having inputs connected to the comparator outputs and having an output forming a real time digital temporal output of the laser spot detecting device.

2. A device according to claim 1, wherein the global OR circuit (21) comprises a plurality of open drain transistors (22), with each open drain transistor being connected to an output of a comparator of one of the pulse detecting elementary circuits and forming an open drain output of this pulse detecting elementary circuit.

3. A device according to claim 2, wherein the open drain outputs of the pulse detecting elementary circuits connected to the elementary optoelectronic detectors located on a same line of the matrix sensor are connected together for summing said open drain outputs, and thus form a line signal (S1).

4. A device according to claim 3, wherein the global OR circuit further comprises components arranged for summing together the line signals and thus form the temporal output of the spot laser detecting device (0; 100) .

5. A device according to one of the preceding claims, wherein an input of the comparator of each pulse detecting elementary circuit is connected to the memory module, and wherein the output of the multiplexing circuit also forms an analog spatial output of the detecting device.

6. A device according to claim 5, wherein each memory module includes a first memory (30) and a second memory (31).

7. A device according to claim 6, wherein each pulse detecting elementary circuit further comprises a selector having as inputs the comparator input and the comparator output and having an output connected to the first memory and to the second memory.

8. A device according to claim 6, wherein the first memory (30) and/or the second memory (31) comprise(s) a sample and hold circuit.

9. A method for detecting a laser spot implemented by a laser spot detecting device according to one of the preceding claims, with said method for detecting a laser spot comprising a verification step in which the temporal output of the laser spot detecting device is used for determining a duration of a laser pulse and/or a period of time between two successive laser pulses.

10. A detection method according to claim 9, wherein the duration of a laser pulse and/or the period of time between two successive laser pulses is/are used to verify that the laser pulse actually corresponds to a target laser spot.

11. A method according to claim 9, wherein, as the device is provided with an analog spatial output, the analog spatial output is used when several digitized laser pulses have a consistent width and a consistent length between two successive digitized pulses for radiometry discriminating for distinguishing the valid digitized laser pulses and the parasitic digitized laser pulses.

12. A method according to claim 9, with each memory module having a first memory {30) and a second memory (31) each comprising a sample and hold circuit, with each pulse detecting elementary circuit further comprising a selector having as inputs the comparator input and the comparator output and having an output connected to the first memory and to the second memory, with the sample and hold circuits being controlled for storing the either digital or analog laser pulses.
